# EUROPEAN PATENT APPLICATION

(11) **EP 4 456 143 A1**
(43) Date of publication of application: **30.10.2024**
(21) Application number: 23170287.9
(22) Date of filing: 27.04.2023
(51) Int. Cl.: H01L 29/775, H01L 21/336, H01L 29/06, H01L 29/423, B82Y 10/00

(54) **METHODS OF MAKING NANOSHEET BASED DEVICES**

(71) Applicant: Huawei Technologies Co., Ltd., Shenzhen, Guangdong 518129 (CN)
(72) Inventor: Bhuwalka, Krishna Kumar, 80992 Munich (DE)
(74) Representative: Körber, Martin Hans

(57) **Abstract**

This disclosure relates to nanosheet based devices, especially to gate all around (GAA) nanosheet transistors. A GAA nanosheet transistor of this disclosure comprises a substrate layer and a stack comprising two or more gate-metal layers and one or more channel layers, which are alternatingly stacked along a first direction on the substrate layer. Thereby, each channel layer is sandwiched in the first direction by two of the gate-metal layers. The top gate-metal layer of the two or more gate-metal layers, which has the largest distance of all the gate-metal layers to the substrate layer, has a length that is smaller than a length of each other gate-metal layer of the two or more gate-metal layers.

## Description

### TECHNICAL FIELD

The present disclosure relates to nanosheet based devices, especially gate all around (GAA) nanosheet transistors and memory or processing devices based on nanosheet transistors. The disclosure proposes a GAA nanosheet transistor with different gate lengths, a memory and/or processing device including at least one such GAA nanosheet transistor, and a method for fabricating the GAA nanosheet transistor.

### BACKGROUND

GAA nanosheet or nanowire transistor devices have been proposed as an alternative to fin field-effect transistor (FinFET) devices for CMOS logic applications. In a GAA nanosheet transistor, several nanosheet channel layers are stacked alternatingly with gate-metal layers, and are surrounded by a gate-metal structure that is connected to the gate-metal layers. Compared to a FinFET, the GAA nanosheet transistors may deliver more drive current due to an increased channel width in the same circuit footprint, and the GAA design may improve channel control and may minimize short-channel effects.

Moreover, GAA nanosheet transistors allow for a marginally better gate-length scaling than is possible for FinFETs, which is due to the better minimized short-channel effects. However, an aggressive gate-length scaling is still not possible in a GAA nanosheet transistor, mainly because the widths of the nanosheets forming the channel layers. Typically, an aspect ratio of the nanosheet width to the nanosheet thickness is in the order of >4, which results in effective two-side confinement effects rather than GAA effects.

### SUMMARY

In view of the above, this disclosure has the objective to provide a solution for enabling a more aggressive gate length scaling. An objective thus is to provide a GAA nanosheet transistor that allows shorter gate lengths.

These and other objectives are achieved by this disclosure as described in the independent claims. Advantageous implementations are described in the dependent claims.

A first aspect of this disclosure provides a GAA nanosheet transistor comprising: substrate layer; two or more gate-metal layers and one or more channel layers, which are alternatingly stacked along a first direction on the substrate layer; wherein each channel layer is sandwiched in the first direction by two of the gate-metal layers; wherein a top gate-metal layer of the two or more gate-metal layers, which has the largest distance of all the gate-metal layers to the substrate layer, has a length that is smaller than a length of each other gate-metal layer of the two or more gate-metal layers.

The GAA nanosheet transistor of the first aspect allows for an aggressive on-mask gate-length scaling by decoupling the length of the top (outer) gate metal-layer from the lengths of the other (inner) gate-metal layers. The gate length of the outer gate-metal layer may be mask-defined, while the gate length of the inner gate-metal layers may be defined by an inner spacer thickness and a source/drain (S/D) contact structure etch profile. Thus, these gate lengths may be decoupled from each other in the fabrication process. The inner gate length may determine the physical gate length of the GAA nanosheet transistor.

In an implementation form of the first aspect, the top gate-metal layer has a first length, each other gate-metal layer of the two or more gate-metal layers has a second length, and the second length is larger than the first length.

That is, all inner gate-metal layers may have the same inner gate length.

In an implementation form of the first aspect, the second length is more than 10 nm, or more than 13 nm, or more than 15 nm.

In an implementation form of the first aspect, the first length is less than 11 nm, or less than 10 nm, or less than 8 nm.

In an implementation form of the first aspect, a ratio of the first length to the second length is in a range of 0.4 - 0.9.

The above parameters achieve particularly good performance results for the GAA nanosheet transistor.

In an implementation form of the first aspect, the GAA nanosheet transistor comprises two or more channel layers; wherein a top channel layer of the two or more channel layers, which has the largest distance of all the channel layers to the substrate layer, has a thickness that is smaller than a thickness of each other channel layer of the two or more channel layers.

Reducing the thickness of the top (outer) channel layer compared to the other (inner) channel layers enables better short-channel control and improves scalability.

In an implementation form of the first aspect, the top channel layer has a first thickness, each other channel layer of the two or more channel layers has a second thickness, and the second thickness is larger than the first thickness.

That is, all inner channel layers may have the same inner channel thickness.

In an implementation form of the first aspect, the second thickness is in a range of 3-6 nm.

In an implementation form of the first aspect, the first thickness is in a range of 2-5 nm.

The above parameters achieve particularly good performance results for the GAA nanosheet transistor.

In an implementation form of the first aspect, the GAA nanosheet transistor further comprises: a first contact structure and a second contact structure, which sandwich the alternatingly stacked gate-metal layers and channel layers in a second direction perpendicular to the first direction; and a plurality of spacers, wherein each spacer separates one of the gate-metal layers from the first contact structure or from the second contact structure.

The contact structures may be S/D contact structures for the GAA nanosheet transistor.

In an implementation form of the first aspect, the plurality of spacers comprises: two top spacers, which separate the top gate-metal layer from the first contact structure and the second contact structure, respectively; and two or more other spacers, which separate the other gate-metal layers from the first contact structure and the second contact structure, respectively; wherein each top spacer has a first spacer width, each other spacer has a second spacer width, and the first spacer width is larger than the second spacer width.

The spacer may thus be used for defining the different gate lengths of the top gate-metal layer and the inner gate-metal layers.

In an implementation form of the first aspect, the first and the second contact structure each comprise: a doped semiconductor, which is arranged next to the other gate-metal layers in the second direction; and a metal contact provided on the doped semiconductor and arranged next to the top gate-metal layer in the second direction.

In an implementation form of the first aspect, the substrate layer comprises doped silicon; and/or the channel layers comprise silicon germanium or germanium or other semiconductor materials.

A second aspect of this disclosure provides a memory and/or processing device comprising at least one GAA nanosheet transistor according to the first aspect or any of its implementation forms.

The device enjoys the advantages of the GAA nanosheet transistor described above, and has a better performance and allows for better gate-length scaling than a conventional device.

A third aspect of this disclosure provides a method for fabricating a GAA nanosheet transistor, the method comprising: forming a substrate layer; forming a stack on the substrate layer; wherein the stack comprises two or more gate-metal layers and one or more channel layers that are alternatingly formed along a first direction; wherein each channel layer is sandwiched in the first direction by two of the gate-metal layers; and wherein a top gate-metal layer of the two or more gate-metal layers, which is formed last and has the largest distance of all the gate-metal layers to the substrate layer, is formed with a length that is smaller than a length with which each other gate-metal layer of the two or more gate-metal layers is formed.

The method of the third aspect may have implementation forms, which correspond to the GAA nanosheet transistor of the first aspect, that is, the method may form each implementation form of the GAA nanosheet transistor. The method of the third aspect and its implementation forms may achieve the same advantages as described above for the GAA nanosheet transistor of the first aspect and its corresponding implementation forms.

### BRIEF DESCRIPTION OF DRAWINGS

The above described aspects and implementation forms will be explained in the following description of specific embodiments in relation to the enclosed drawings, in which;
- FIG. 1: shows the main elements of a GAA nanosheet transistor according to this disclosure.
- FIG. 2: shows an exemplary GAA nanosheet transistor according to this disclosure.
- FIG. 3: shows an exemplary GAA nanosheet transistor according to this disclosure.
- FIG. 4: shows a method according to this disclosure, for fabricating a GAA nanosheet transistor.

### DETAILED DESCRIPTION OF EMBODIMENTS

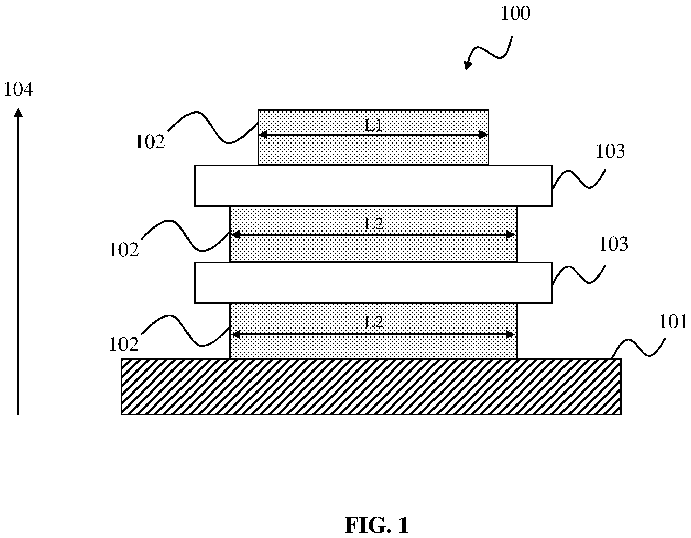

FIG. 1 shows the main elements of a GAA nanosheet transistor 100 according to this disclosure. The GAA nanosheet transistor 100 may be used for or in a memory and/or processing device, for instance, a logic device. Such a memory and/or processing device can include at least one GAA nanosheet transistor 100 according to this disclosure. The GAA nanosheet transistor 100 of this disclosure may be fabricated as PMOS or NMOS transistor.

The GAA nanosheet transistor 100 comprises a substrate layer 101, for instance, a silicon or a silicon-based layer, substrate, or wafer. The substrate layer 101 may comprise doped silicon and/or may comprise a doped silicon-based material.

Further, the GAA nanosheet transistor 100 comprises two or more gate-metal layers 102 and one or more channel layer 103, which are alternatingly stacked along a first direction 104 (one-on-one) on the substrate layer 101. That is, a stack is arranged on the substrate layer 101, and the stack comprises the two or more gate-metal layers 102 and the one or more channel layers 103.

Each channel layer 103 may comprise a channel material, for example, a semiconductor material, like silicon germanium. Each channel layer 103 may further comprise a gate dielectric layer, for instance, comprising an oxide or high-k material, which surrounds the channel material and insulates the channel material from the gate-metal layers 102 arranged adjacent to that channel layer 103. The channel material may be doped.

The gate-metal layers 103 comprise each at least one metal and/or poly-silicon based material, for instance, a suitable (conventional) gate metal, which may be selected based on whether a CMOS or NMOS GAA nanosheet transistor is considered. As each channel layer 103 is sandwiched in the first direction 104 by two of the gate-metal layers 102, one of the gate-metal layers 102 is provided, as first layer of the stack, directly on the substrate layer 101, and another gate-metal layer 102 is provided, as a last layer of the stack, with the greatest distance of all the layers of the stack to the substrate layer 101.

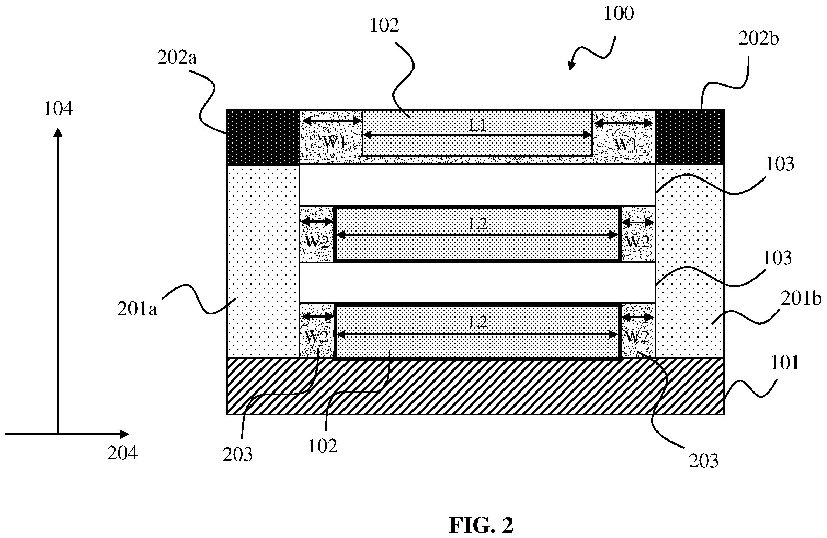

This last gate-metal layer 102 of the stack is referred to as a top gate-metal layer 102 (or outer gate-metal layer 102) of the two or more gate-metal layers 102, as it has the largest distance of all the gate-metal layers 102 to the substrate layer 101. The top gate-metal layer 102 has a length L1 (defined perpendicular to the first direction 104, and along the second direction 204 show in FIG. 2), wherein the length L1 is smaller than a length of each other gate-metal layer 102 of the two or more gate-metal layers 102.

Notably, FIG. 1 shows a GAA nanosheet transistor 100 with three gate-metal layers 102 and two channel layers 103, but this is only an example. Further, FIG. 1 shows that the length of each other gate-metal layer 102 is the same second length L2. However, the gate lengths of the other gate-metal layers 102 can also differ, as long as they are all larger than the first length L1. That is, in the case where all other gate-metal layers 102 have the second length L2, the second length L2 is larger than the first length L1. The first gate length L1 can be less than 11 nm or even less than 10 nm, while the second gate length L2 is, respectively, more than 10 nm or even more than 11 nm. For example, a ratio of the first length L1 to the second length L2 (i.e., the ratio L1/L2) may be anywhere in a range of 0.4 - 0.9.

FIG. 2 shows an exemplary GAA nanosheet transistor 100, which is based on the GAA nanosheet transistor 100 shown in FIG. 1. Same elements in FIG. 1 and FIG. 2 are labelled with the same reference signs and are implemented likewise.

FIG. 2 shows that the exemplary GAA nanosheet transistor 100 furthers comprise a first contact structure 201a, 202a and a second contact structure 201b, 202b, which may be S/D contact structures and sandwich the stack - i.e. the alternatingly stacked gate-metal layers 102 and channel layers 103 - in the second direction 204, which is perpendicular to the first direction 104. The first contact structure 201a, 202a may comprise a first doped semiconductor 201a, and the second contact structure 201b, 202b may comprise a second doped semiconductor structure 201b, which are respectively arranged next to the other gate-metal layers 102 in the second direction 204, i.e., they sandwich these other gate-metal layers 102 in the second direction 204. The doped semiconductors 201a and 201b may be epitaxial semiconductors. The first contact structure 201a, 202a may further comprise a first metal contact 202a, and the second contact structure 201b, 202b may further comprise a second metal contact 202b, which are respectively arranged next to the top gate-metal layer 102 in the second direction 204, i.e., they sandwich the top gate-metal layers 102 in the second direction 204. A conventional metal for an S/D contact may be used.

The GAA nanosheet transistor 100 also comprises a plurality of spacers 203. Each spacer 203 separates one of the gate-metal layers 102 from the first contact structure 201a, 202a or from the second contact structure 201b, 202b, respectively. In particular, each top spacer 203 of two top spacers 203 (also referred to as outer spacers 203) separates the top gate-metal layer 102 from the first metal contact 202a and from the second metal contact 202a, respectively. Each other spacer 203 (also referred to as inner spacers 203) separates one of the other gate-metal layers 102 from either the first doped semiconductor 201a or the second doped semiconductor 201b.

As shown in FIG. 2, each top spacer 203 has a first spacer width W1, and each other spacer 203 has a second spacer width W2. The first spacer width W1 is larger than the second spacer width W2. The spacer widths can be adapted to obtain the gate lengths L1 and L2.

For example, in the GAA nanosheet transistor 100 of FIG. 2, the first (outer) gate length L1 may be scaled by increasing - starting from a conventional structure where all spacers have the same width - the first (outer) spacer width W1 while keeping the second (inner) spacer width fixed. This may lead to a reduction of parasitic capacitances (due to a larger contact between gate layers 102 and the S/D contact structures). Moreover, short-channel effects may be controlled by the second gate length L2. This design also allows a better scaling of the contact gate pitch (CGP) or contact poly pitch (CPP).

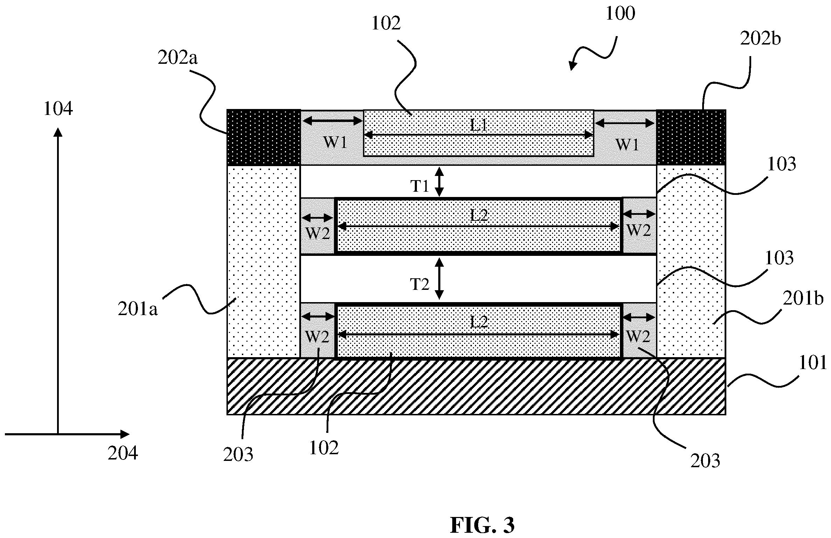

FIG. 3 shows another exemplary GAA nanosheet transistor 100, which is based on the GAA nanosheet transistor 100 shown in FIG. 1 and 2. Same elements in the figures are labelled with the same reference signs and are implemented likewise.

FIG. 3 shows that the GAA nanosheet transistor 100 further comprises channel layers 103 of different thickness (measure along the first direction 104). In particular, the GAA nanosheet transistor 100 may comprise a top channel layer 103, which has the largest distance of all the channel layers 103 to the substrate layer 101. The top channel layer 103 has a thickness T1, which is smaller than a thickness of each other channel layer 103 of the two or more channel layers 103. While the thicknesses of all the other channel layers 103 may not have to be all the same, as long as they are larger than the thickness T1, as shown in FIG. 3 each other channel layer 103 may have the same second thickness T2. The second thickness T2 is larger than the first thickness T1. For example, the second thickness T2 may be in a range of 3-6 nm, and the first thickness T1 may be in a range of 2-5 nm.

Reducing the top channel layer (nanosheet) thickness T1 compared to T2, enables better short-channel control and leads to improved scalability.

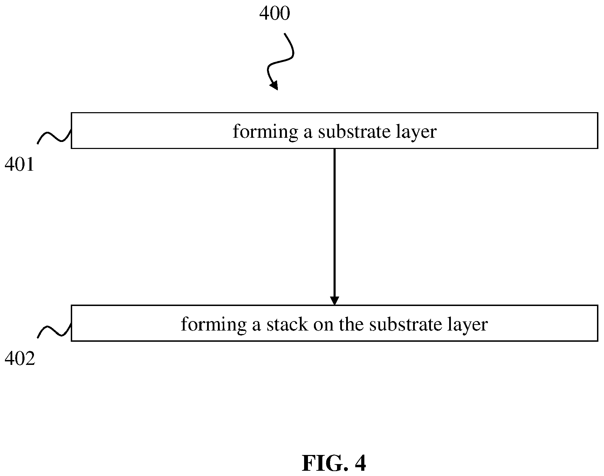

FIG. 4 shows steps of a method 400 according to this disclosure, which is suitable for fabricating any of the exemplary GAA nanosheet transistors 100 described above and shown in the FIG.s 1-3. The method 400 may comprise a step 401 of forming the substrate layer 101, and a step 402 of forming 402 the stack on the substrate layer 101. The stack comprises the two or more gate-metal layers 102 and the one or more channel layers 103, which are alternatingly formed along the first direction 104. Each channel layer 103 is sandwiched in the first direction 104 by two of the gate-metal layers 102. The top gate-metal layer 102 of the two or more gate-metal layers 102, which is formed last and has the largest distance of all the gate-metal layers 102 to the substrate layer 101, is formed with a length L1, which is smaller than any length, with which any other gate-metal layer 102 of the two or more gate-metal layers 102 is formed. The other gate-metal layers 102 may all have the length L2, which is larger than L1.

Electrical results obtained by comparing various GAA nanosheet transistors 100 according to this disclosure with other GAA nanosheet transistors not according to this disclosure show that an optimum performance is achieved at a scaled first (outer) gate length L1, while having relaxed inner gate lengths. Thereby, all inner gate-layers 102 may have the same inner gate length L2. With L1<L2, a 10-15% performance enhancement is possible. In particular, all circuit metrics may be improved due to improvements of the effective capacitance (C_{EFF}) and S_{SAT}.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A gate all around, GAA, nanosheet transistor (100) comprising:
a substrate layer (101);
two or more gate-metal layers (102) and one or more channel layers (103), which are alternatingly stacked along a first direction (104) on the substrate layer (101);
wherein each channel layer (103) is sandwiched in the first direction (104) by two of the gate-metal layers (102);
wherein a top gate-metal layer (102) of the two or more gate-metal layers (102), which has the largest distance of all the gate-metal layers (102) to the substrate layer (101), has a length (L1) that is smaller than a length (L2) of each other gate-metal layer (102) of the two or more gate-metal layers (102).

2. The GAA nanosheet transistor (100) according to claim 1, wherein the top gate-metal layer (102) has a first length (L1), each other gate-metal layer (102) of the two or more gate-metal layers (102) has a second length (L2), and the second length (L2) is larger than the first length (L1).

3. The GAA nanosheet transistor (100) according to claim 2, wherein the second length (L2) is more than 10 nm, or more than 13 nm, or more than 15 nm.

4. The GAA nanosheet transistor (100) according to one of the claims 1 to 3, wherein the first length (L1) is less than 11 nm, or less than 10 nm, or less than 8 nm.

5. The GAA nanosheet transistor (100) according to one of the claims 2 to 4, wherein a ratio of the first length (L1) to the second length (L2) is in a range of 0.4 - 0.9.

6. The GAA nanosheet transistor (100) according to one of the claims 1 to 5 comprising two or more channel layers (103);
wherein a top channel layer (103) of the two or more channel layers (103), which has the largest distance of all the channel layers (103) to the substrate layer (101), has a thickness (T1) that is smaller than a thickness (T2) of each other channel layer (103) of the two or more channel layers (103).

7. The GAA nanosheet transistor (100) according to claim 6, wherein the top channel layer (103) has a first thickness (T1), each other channel layer (102) of the two or more channel layers (103) has a second thickness (T2), and the second thickness (T2) is larger than the first thickness (T1).

8. The GAA nanosheet transistor (100) according to claim 7, wherein the second thickness (T2) is in a range of 3-6 nm.

9. The GAA nanosheet transistor (100) according to claim 7 or 8, wherein the first thickness (T1) is in a range of 2-5 nm.

10. The GAA nanosheet transistor (100) according to one of the claims 1 to 9, further comprising:
a first contact structure (201a, 202a) and a second contact structure (201b, 202b), which sandwich the alternatingly stacked gate-metal layers (102) and channel layers (103) in a second direction (204) perpendicular to the first direction (104); and
a plurality of spacers (203), wherein each spacer (203) separates one of the gate-metal layers (102) from the first contact structure (201a, 202a) or from the second contact structure (201b, 202b).

11. The GAA nanosheet transistor (100) according to claim 10, wherein the plurality of spacers (203) comprises:
two top spacers (203), which separate the top gate-metal layer (102) from the first contact structure (201a, 202a) and the second contact structure (201b, 202b), respectively; and
two or more other spacers (203), which separate the other gate-metal layers (102) from the first contact structure (201a, 202a) and the second contact structure (201b, 202b), respectively;
wherein each top spacer (203) has a first spacer width (W1), each other spacer (203) has a second spacer width (W2), and the first spacer width (W1) is larger than the second spacer width (W2).

12. The GAA nanosheet transistor (100) according to claim 10 or 11, wherein the first and the second contact structure (201a, 202a, 201b, 202b) each comprise:
a doped semiconductor (201a, 201b), which is arranged next to the other gate-metal layers (102) in the second direction (204); and
a metal contact (202a, 202b) provided on the doped semiconductor (201a, 201b) and
arranged next to the top gate-metal layer (202a, 202b) in the second direction (204).

13. The GAA nanosheet transistor (100) according to one of the claims 1 to 12, wherein:
the substrate layer (101) comprises doped silicon; and/or
the channel layers (103) comprise silicon germanium.

14. A memory and/or processing device comprising at least one GAA nanosheet transistor (100) according to one of the claims 1 to 13.

15. A method (400) for fabricating a gate all around, GAA, nanosheet transistor (100), the method (400) comprising:
forming (401) a substrate layer (101);
forming (402) a stack on the substrate layer (101);
wherein the stack comprises two or more gate-metal layers (102) and one or more channel layers (103) that are alternatingly formed along a first direction (104);
wherein each channel layer (103) is sandwiched in the first direction (104) by two of the gate-metal layers (102); and
wherein a top gate-metal layer (102) of the two or more gate-metal layers (102), which is formed last and has the largest distance of all the gate-metal layers (102) to the substrate layer (101), is formed with a length (L1) that is smaller than a length (L2) with which each other gate-metal layer (102) of the two or more gate-metal layers (102) is formed.

## Amended claims

### Amended claims in accordance with Rule 137(2) EPC.

1. A gate all around, GAA, nanosheet transistor (100) comprising:
a substrate layer (101);
a plurality of gate-metal layers (102) comprising more than two gate-metal layers (102) and a plurality of channel layers (103), comprising more than two channel layers (103), which are alternatingly stacked along a first direction (104) on the substrate layer (101);
wherein each channel layer (103) is sandwiched in the first direction (104) by two of the gate-metal layers (102);
wherein a top gate-metal layer (102) of the plurality of gate-metal layers (102), which has the largest distance of all the gate-metal layers (102) to the substrate layer (101), has a length (L1) that is smaller than a length (L2) of each other gate-metal layer (102) of the two or more gate-metal layers (102);
wherein a top channel layer (103) of the plurality of channel layers (103), which has the largest distance of all the channel layers (103) to the substrate layer (101), has a thickness (T1) that is smaller than a thickness (T2) of each other channel layer (103) of the plurality of channel layers (103); and
wherein the top channel layer (103) has a first thickness (T1), each other channel layer (103) of the plurality of channel layers (103) has a second thickness (T2), and the second thickness (T2) is larger than the first thickness (T1).

2. The GAA nanosheet transistor (100) according to claim 1, wherein the top gate-metal layer (102) has a first length (L1), each other gate-metal layer (102) of the plurality of gate-metal layers (102) has a second length (L2), and the second length (L2) is larger than the first length (L1).

3. The GAA nanosheet transistor (100) according to claim 2, wherein the second length (L2) is more than 10 nm, or more than 13 nm, or more than 15 nm.

4. The GAA nanosheet transistor (100) according to one of the claims 1 to 3, wherein the first length (L1) is less than 11 nm, or less than 10 nm, or less than 8 nm.

5. The GAA nanosheet transistor (100) according to one of the claims 2 to 4, wherein a ratio of the first length (L 1) to the second length (L2) is in a range of 0.4 - 0.9.

6. The GAA nanosheet transistor (100) according to claim 1, wherein the second thickness (T2) is in a range of 3-6 nm.

7. The GAA nanosheet transistor (100) according to claim 1 or 6, wherein the first thickness (T1) is in a range of 2-5 nm.

8. The GAA nanosheet transistor (100) according to one of the claims 1 to 7, further comprising:
a first contact structure (201a, 202a) and a second contact structure (201b, 202b), which sandwich the alternatingly stacked gate-metal layers (102) and channel layers (103) in a second direction (204) perpendicular to the first direction (104); and
a plurality of spacers (203), wherein each spacer (203) separates one of the plurality gate-metal layers (102) from the first contact structure (201a, 202a) or from the second contact structure (201b, 202b).

9. The GAA nanosheet transistor (100) according to claim 8, wherein the plurality of spacers (203) comprises:
two top spacers (203), which separate the top gate-metal layer (102) from the first contact structure (201a, 202a) and the second contact structure (201b, 202b), respectively; and
two or more other spacers (203), which separate the other gate-metal layers of the plurality of gate-metal layers (102) from the first contact structure (201a, 202a) and the second contact structure (201b, 202b), respectively;
wherein each top spacer (203) has a first spacer width (W1), each other spacer (203) has a second spacer width (W2), and the first spacer width (W1) is larger than the second spacer width (W2).

10. The GAA nanosheet transistor (100) according to claim 8 or 9, wherein the first and the second contact structure (201a, 202a, 201b, 202b) each comprise:
a doped semiconductor (201a, 201b), which is arranged next to the other gate-metal layers of the plurality of gate-metal layers (102) in the second direction (204); and
a metal contact (202a, 202b) provided on the doped semiconductor (201a, 201b) and arranged next to the top gate-metal layer (202a, 202b) in the second direction (204).

11. The GAA nanosheet transistor (100) according to one of the claims 1 to 10, wherein:
the substrate layer (101) comprises doped silicon; and/or
the channel layers (103) comprise silicon germanium.

12. A memory and/or processing device comprising at least one GAA nanosheet transistor (100) according to one of the claims 1 to 11.

13. A method (400) for fabricating a gate all around, GAA, nanosheet transistor (100), the method (400) comprising:
forming (401) a substrate layer (101);
forming (402) a stack on the substrate layer (101);
wherein the stack comprises a plurality of gate-metal layers (102) comprising more than two gate-metal layers (102) and a plurality of channel layers (103) comprising more than two channel layers (103) that are alternatingly formed along a first direction (104);
wherein each channel layer (103) is sandwiched in the first direction (104) by two of the gate-metal layers (102);
wherein a top gate-metal layer (102) of the plurality of gate-metal layers (102), which is formed last and has the largest distance of all the gate-metal layers (102) to the substrate layer (101), is formed with a length (L1) that is smaller than a length (L2) with which each other gate-metal layer (102) of the plurality of gate-metal layers (102) is formed;
wherein a top channel layer (103) of the plurality of channel layers (103), which has the largest distance of all the channel layers (103) to the substrate layer (101), is formed with a thickness (T1) that is smaller than a thickness (T2) with which each other channel layer (103) of the plurality of channel layers (103) is formed; and
wherein the top channel layer (103) is formed with a first thickness (T1), each other channel layer (103) of the plurality of channel layers (103) is formed with a second thickness (T2), and the second thickness (T2) is larger than the first thickness (T1).
